Europäisches Patentamt

European Patent Office

Office européen des brevets

(19)

(11) **EP 0 630 100 B1**

(12) **EUROPEAN PATENT SPECIFICATION**

(45) Date of publication and mention
of the grant of the patent:
**28.11.2001 Bulletin 2001/48**

(51) Int Cl.7: **H03F 1/08**

(21) Application number: **94201703.9**

(22) Date of filing: **14.06.1994**

(54) **Amplifier arrangement with multipath Miller zero cancellation**

Verstärkungsanordnung mit Vielweg-Millernullunterdrückung

Dispositif amplificateur à suppresion multivoie de zéro miller

(84) Designated Contracting States:
**DE FR GB IT NL**

(30) Priority: **21.06.1993 EP 93201779**

(43) Date of publication of application:
**21.12.1994 Bulletin 1994/51**

(73) Proprietor: **Koninklijke Philips Electronics N.V.**
**5621 BA Eindhoven (NL)**

(72) Inventors:
 • **Huijsing, Johan H.**
 **NL-5656 AA Eindhoven (NL)**
 • **Eschauzier, Rudolphe G.H.**
 **NL-5656 AA Eindhoven (NL)**

(74) Representative:
**Groenendaal, Antonius Wilhelmus Maria et al**
**INTERNATIONAAL OCTROOIBUREAU B.V.,**
**Prof. Holstlaan 6**
**5656 AA Eindhoven (NL)**

(56) References cited:
**EP-A- 0 499 308     FR-A- 2 575 620**
**US-A- 4 980 651**

## Description

The invention relates to an amplifier arrangement comprising an inverting transconductance stage having an input and an output for providing an output voltage $U_{out}$; a capacitor coupled between the input and the output of the inverting transconductance stage; and signal current means having a first output coupled to the input of the inverting transconductance stage to provide a first signal current $I_{in}$ to the input of the inverting transconductance stage, the signal current means further comprising a second output coupled to the output of the inverting transconductance stage to provide a second signal current to the output of the inverting transconductance stage, which second signal current is substantially in phase opposition and substantially equal in magnitude to the first signal current.

Such an amplifier arrangement is known from US 4 980 651 which discloses a DC-coupled multistage operational amplifier, the participation of the multiple stages of which, in defining the effective gain of the amplifier, is frequency dependent, such that high frequency signals are amplified by a single high speed stage and coupled directly to an output port. Low frequencies, on the other hand, are coupled through both the high speed stage and a low frequency precision stage connected in cascade with the high speed stage. Tuning capacitors are coupled to the low frequency precision stage resulting in a transfer function of the operational amplifier containing two primary poles at frequencies below a frequency at which unity gain occurs and a zero at less than the unity gain frequency and greater than the frequencies of the poles.

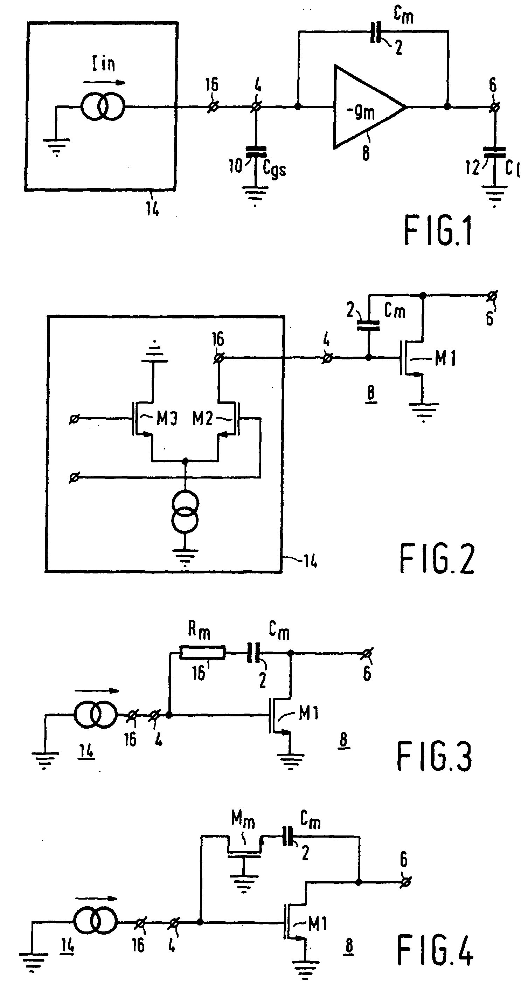

The theoretical background of such an amplifier arrangement is known, for example, from a paper by P.R. Gray *et al.,* "MOS Operational Amplifier Design - A Tutorial Overview", IEEE Journal of Solid State Circuits, Vol. SC-17, No. 6, December 1982, pp. 969-982. A very well known and widespread frequency-compensation method for amplifiers is Miller compensation or pole splitting, as shown in Fig. 1. Placing a Miller capacitor 2 between the input 4 and the output 6 of an inverting transconductance stage 8 splits the input and output poles caused by the capacitances 10 and 12 at the input 4 and the output 6, resulting in a well-controlled 20 dB/decade frequency roll-off. The transconductance stage 8 is driven by a signal source 14 having an output 16 coupled to the input 4 to supply a signal current $I_{in}$ to the transconductance stage. Fig. 2 shows a simple Miller-compensated amplifier in which the inverting transconductance stage 8 is formed by a transistor M1 and the signal source 14 by a differential transistor pair M2-M3. A disadvantage of the Miller technique is the zero appearing in the right-half of the s-plane of the complex transfer function of the amplifier arrangement. This Right Half-Plane (RHP) zero severely degrades the phase margin of the amplifier. The zero is caused by the direct path the Miller capacitor 2 creates from the input 4 to the output 6. Signal current taking this path is in phase opposition to the output current of the inverting transconductance stage 8. It can easily be understood that this opposite phase current reduces the bandwidth in a feedback system because the sign of the feedback changes from negative to positive for high frequencies. The position of the RHP zero is $z = g_m/C_m$, where $g_m$ is the transconductance of the inverting transconductance stage 8 and $C_m$ the capacitance of the Miller capacitor 2. As the expression for the zero reveals, the influence of the RHP zero is inversely proportional to the transconductance $g_m$ of the inverting transconductance stage 8. Both bipolar and MOS circuits suffer from the effects of the RHP zero. Since MOS transistors normally have a lower transconductance than bipolar transistors MOS circuits are most strongly affected. In many cases the RHP zero determines the maximum bandwidth of a MOS amplifier. However, the RHP zero can also be a bandwidth limiting factor in bipolar designs.

In the past some measures to counteract the RHP zero have been proposed. A classic solution, also known from the afore-mentioned paper, is to insert a small resistor 16 in series with the Miller capacitor 2, as is shown in Fig. 3. Increasing the value $R_m$ of the resistor 16 shifts the RHP zero towards infinity. As the resistor value increases even more the zero will reappear in the Left Half-Plane. No zero will be present when $R_m = 1/g_m$. As the optimum value $R_m$ of the compensation resistor 16 depends on the transconductance $g_m$ problems arise when the transconductance is not constant, for example, when the current through the transistor M1 has a large dynamic range. This is likely to occur in an output stage. In this situation the compensation can only be optimised for one value of the output current of the inverting transconductance stage, for example for the quiescent current. For all other output currents the compensation is suboptimal. Since the bandwidth of an amplifier depends on the worst-case position of the RHP zero not much bandwidth improvement can be expected from the compensation resistor 16.

Other propositions to eliminate the RHP zero are based on removing the direct path through the Miller capacitor 2. By inserting a unilateral element in the Miller capacitor branch direct feed-through is suppressed. Fig. 4 shows an implementation with a current buffer known from a paper by B.K. Ahuja, "An Improved Frequency Compensation Technique for CMOS Operational Amplifiers", IEEE Journal of Solid-State Circuits, Vol. SC-18, No. 6, December 1983, pp. 629-633. A common gate transistor $M_m$ in series with a Miller capacitor 2 serves as the current buffer. A disadvantage of this approach is the addition of an active element, with its associated poles, in the Miller feedback path. These poles deteriorate the high frequency performance and the remedy is worse than the disease.

It is an object of the invention to provide a technique which eliminates the Right Half-Plane zero in Miller compensated amplifier arrangements but without the above problems. According to the present invention an amplifier arrangement as specified in the opening paragraph is characterized in that the amplifier arrangement has a complex transfer function $U_{out}/I_{in}$ between the output and the input having a zero in the left half-plane of the complex transfer function at a frequency outside the pass-band of the amplifier arrangement.

A Multi-path Miller Zero Cancellation (MMZC) technique is proposed, which provides a parallel path to the output of the inverting transconductance stage, compensating for the current directly passing through the Miller capacitor. As a result of the parallel nature no additional poles are introduced. In addition, the operation of the MMZC is independent of the transconductance of the inverting transconductance stage. Optimum results may be obtained when the second signal current is substantially equal in magnitude to the first output current.

The MMZC technique can be used advantageously in a Multipath Nested Miller Integrator Structure known from United States Patent No. 5,155,477. For this purpose an embodiment of an amplifier arrangement according to the invention is further characterized in that the signal current means comprises a second transconductance stage having an input, a non-inverting output coupled to the input of the inverting transconductance stage, and an inverting output coupled to the output of the inverting transconductance stage, and in that the amplifier arrangement further comprises a second capacitor coupled between the output of the inverting transconductance stage and the input of the second transconductance stage; and a third transconductance stage having an input, a first non-inverting output coupled to the non-inverting output of the second transconductance stage, a second non-inverting output coupled to the input of the second transconductance stage, and an inverting output coupled to the output of the inverting transconductance stage.

The above and other features and advantages of the invention will be apparent from the following description of exemplary embodiments of the invention with reference to the accompanying drawings, in which:

Figures 1 to 4 are circuit diagrams of prior-art Miller-compensated amplifier arrangements,
Figure 5 is a basic circuit diagram of a Miller-compensated amplifier arrangement according to the invention,
Figure 6 is a circuit diagram of an embodiment of a Miller-compensated amplifier arrangement according to the invention,
Figure 7 is a block diagram of a known multipath nested Miller-integrated structure provided with a Miller-compensated amplifier arrangement according to the invention, and
Figure 8 is a circuit diagram of an implementation with bipolar transistors of the structure shown in Figure 7.

Throughout the drawings similar reference signs denote similar parts.

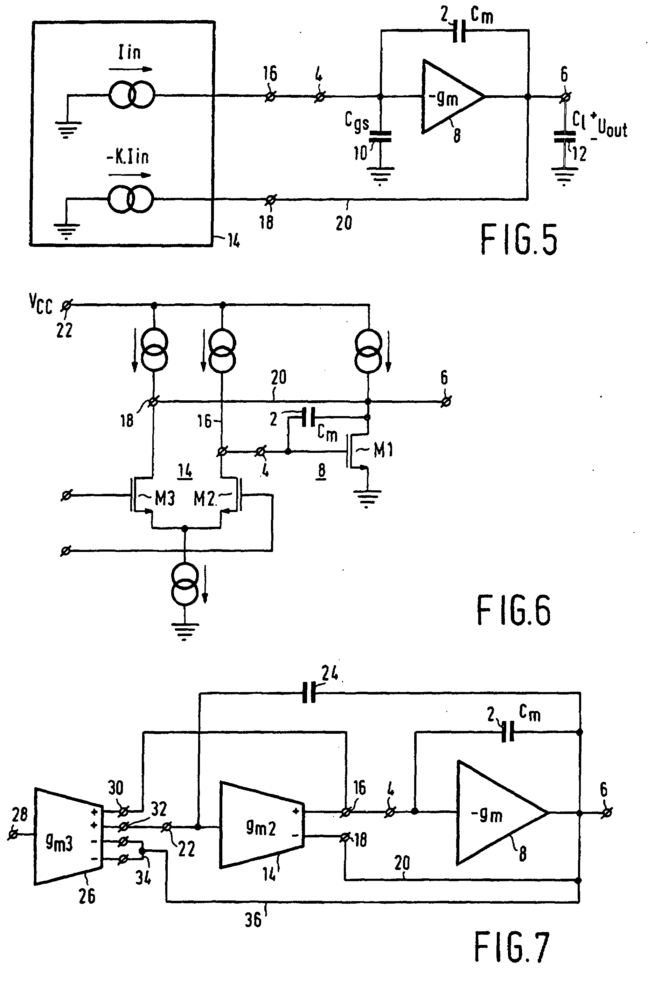

Fig. 5 illustrates the principle of operation of the Multipath Miller Zero Cancellation (MMZC) technique. The circuit shown in Fig. 5 is basically the same as the circuit shown in Fig. 1. However, the signal current means 14 further have a second output 18, which is coupled to the output 6 of the inverting transconductance stage 8 and which provides a signal current $-k*I_{in}$ which is proportional and in phase opposition to the signal current $I_{in}$ of output 16. This provides a parallel path 20 which counteracts the current flowing through the Miller capacitor 2. The complex transfer function of the Fig. 5 circuit can be written as:

$$\frac{U_{out}}{I_{in}} = \frac{-g_m + sC_m - ks(C_m + C_{gs})}{s(s(C_l C_m + C_l C_{gs} + C_m C_{gs}) + C_m g_m)} \quad (1)$$

The constant k in equation (1) determines the extent to which the parallel path 20 is active. The absence of k in the denominator of equation (1) demonstrates that the parallel path 20 has no influence on the positions of the poles. Looking at the numerator, the effect of the parallel path 20 on the zero can be determined. Setting k = 1 leads to the following zero position:

$$z = -\frac{g_m}{C_{gs}} \quad (2)$$

As equation (2) indicates, the zero changes place from the Right to the Left Half-Plane. In practical applications this zero will be outside the pass-band of the amplifier arrangement. Moreover, in the left half of the s-plane the zero improves rather than worsens the phase margin of the amplifier.

Fig. 6 shows a preferred embodiment of the MMZC technique. The signal current means 8 comprises a differential transistor pair M2-M3 and the inverting transconductance stage 8 is a single transistor M1. The drain of the transistor M1 constitutes the output 6 of the inverting transconductance stage 8, the gate is the input 4 of the inverting transconductance stage 8, and the source is coupled to ground. The drains of the transistors M2 and M3 constitute the first and the second output 16 and 18 of the signal current means 14 and are coupled to the input 4 and the output 6, respectively. The drains of the transistors M1, M2 and M3 are coupled to a supply terminal 22 via respective bias current sources. The parallel path 20 is fed by the transistor M3. The current in the parallel path 20 and the drain current of transistor M2 have the same magnitude but are of opposite phase. Since most of the drain current of transistor M2 flows into the Miller capacitor 2 the current in the parallel path compensates for this feed-through. The transistor M2, the transistor M3 and the Miller capacitor 2 form a closed loop, effectively isolating the input differential pair M2-M3 from the output 6.

The MMZC technique can be used in the Multipath Nested Miller Structure known from United States Patent No. 5,155,447. Fig. 7 shows a block diagram of such a structure, which is equivalent to the structure disclosed in Fig. 7 of said Patent. The signal current means 14 and the inverting transconductance stage 8 are coupled as shown in Fig. 5. The signal current means 14 has an input 22 to form a second transconductance stage with the inverting output 18 and the non-inverting output 16 in a fashion, for example, as shown in Fig. 6. A second Miller capacitor 24 is connected between the output 6 and an input 24 of the signal current means 14 to form a Nested Miller Structure. A third transconductance stage 26 has an input 28, first and second non-inverting outputs 30 and 32, which are coupled to the input 22 and the non-inverting output 16, respectively, of the second transconductance stage 14 in order to form the Multipath Nested Miller Structure as shown in Fig. 7 of said Patent, and an inverting output 34, which is coupled to the output 6 via a path 36 in order to also form a Multipath Miller Zero Cancellation structure according to this invention.

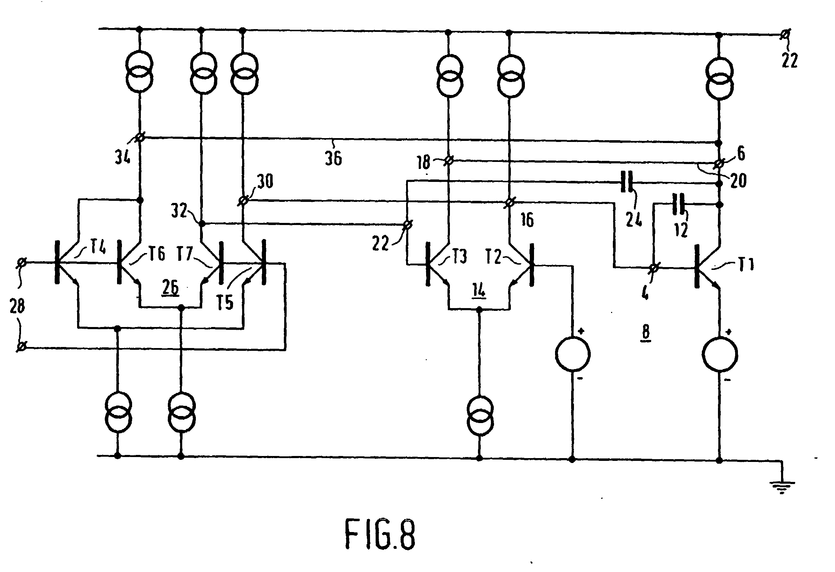

Fig. 8 shows an implementation of the structure shown in Fig. 7, using bipolar transistors. The inverting transconductance stage 8 and the second transconductance stage 14 are basically as shown in Fig. 6. The base of the transistor T2 of the second transconductance stage 14 and the emitter of the transistor T1 of the first transconductance stage 8 are connected to ground via suitable bias voltage sources. The third transconductance stage 26 is a double differential pair T4/T5 and T6/T7 with common input terminals 28. The emitters of pair T4/T5 and the emitters of pair T6/T7 are coupled to ground *via* separate bias current sources. In an alternative embodiment both pairs may be coupled to ground *via* a common bias current source. Other alternative embodiments can be found in the said Patent. The second, the third and the fourth transconductance stage shown therein should be extended with inverting outputs equal in number to the number of non-inverting outputs already present, which inverting outputs are to be coupled to the output 6 as shown in Fig. 7.

From the above it will be obvious to those having ordinary skill in the art that many changes and variations may be made based on the above-described invention without departing from the underlying principles thereof.

## Claims

1. An amplifier arrangement comprising an inverting transconductance stage (8) having an input (4) and an output (6) for providing an output voltage $U_{out}$; a capacitor (2) coupled between the input (4) and the output (6) of the inverting transconductance stage (8); and signal current means (14) having a first output (16) coupled to the input (4) of the inverting transconductance stage (8) to provide a first signal current $I_{in}$ to the input (4) of the inverting transconductance stage (8), the signal current means (14) further comprising a second output (18) coupled to the output (6) of the inverting transconductance stage (8) to provide a second signal current to the output (6) of the inverting transconductance stage (8), which second signal current is substantially in phase opposition and substantially equal in magnitude to the first signal current, **characterized in that** the amplifier arrangement has a complex transfer function $U_{out}/I_{in}$ between the output (6) and the input (4) having a zero in the left half-plane of the complex transfer function at a frequency outside the pass-band of the amplifier arrangement.

2. An amplifier arrangement as claimed in claim 1, **characterized in that** the signal current means (14) comprises a second transconductance stage having an input (22), a non-inverting output (16) coupled to the input (4) of the inverting transconductance stage (8), and an inverting output (18) coupled to the output (6) of the inverting transconductance stage (8).

3. An amplifier arrangement as claimed in claim 2, **characterized in that** the amplifier arrangement further comprises a second capacitor (24) coupled between the output (6) of the inverting transconductance stage (6) and the input (22) of the second transconductance stage (14); and a third transconductance stage (26) having an input (28), a first non-inverting output (30) coupled to the non-inverting output (16) of the second transconductance stage (14), a second non-inverting output (32) coupled to the input (22) of the second transconductance stage (14) and an inverting output (34) coupled to the output (6) of the inverting transconductance stage (6).

## Patentansprüche

1. Verstärkeranordnung mit: einer invertierenden Transkonduktanzstufe (8) mit einem Eingang (4) und einem Ausgang (6) zum Liefern einer Ausgangsspannung $U_{out}$; einem Kondensator (2), der zwischen den Eingang (4) und den Ausgang (6) der invertierenden Transkonduktanzstufe (8) gekoppelt ist; und Signalstrommitteln (14) mit einem ersten Ausgang (16), der mit dem Eingang (4) der invertierenden Transkonduktanzstufe (8) gekoppelt ist, um einen ersten Signalstrom $I_{in}$ an den Eingang (4) der invertierenden Transkonduktanzstufe (8) zu liefern, wobei die Signalstrommittel (14) weiterhin einen zweiten Ausgang (18) umfassen, der mit dem Ausgang (6) der invertierenden Transkonduktanzstufe (8) gekoppelt ist, um einen zweiten Signalstrom an den Ausgang (6) der invertierenden Transkonduktanzstufe (8) zu liefern, wobei der zweite Signalstrom in seiner Phase im Wesentlichen entgegengesetzt zur Phase des ersten Signalstroms ist und in seiner Größe der Größe des ersten Signalstroms entspricht, **dadurch gekennzeichnet, dass** die Verstärkeranordnung eine komplexe Transferfunktion $U_{out} / I_{in}$ zwischen dem Ausgang (6) und dem Eingang (4) hat, bei der eine Null in der linken Halb-Ebene der komplexen Transferfunktion bei einer Frequenz außerhalb des Durchlassbereiches der Verstärkeranordnung vorhanden ist.

2. Verstärkeranordnung nach Anspruch 1, **dadurch gekennzeichnet, dass** das Signalstrommittel (14) eine zweite Transkonduktanzstufe mit einem Eingang (22), einem nicht-invertierenden Ausgang (16) verbunden mit dem Eingang (4) der invertierenden Transkonduktanzstufe (8), und einem invertierenden Ausgang (18) verbunden mit dem Ausgang (6) der invertierenden Transkonduktanzstufe (8) umfasst.

3. Verstärkeranordnung nach Anspruch 2, **dadurch gekennzeichnet, dass** die Verstärkeranordnung weiterhin einen zweiten Kondensator (24) enthält, der zwischen den Ausgang (6) der invertierenden Transkonduktanzstufe (8) und den Eingang (22) der zweiten Transkonduktanzstufe (14) gekoppelt ist; und eine dritte Transkonduktanzstufe (26) mit einem Eingang (28), einem ersten nicht-invertierenden Ausgang (30) verbunden mit dem nicht-invertierenden Ausgang (16) der zweiten Transkonduktanzstufe (14), einem zweiten nicht-invertierenden Ausgang (32) verbunden mit dem Eingang (22) der zweiten Transkonduktanzstufe (14), und einem invertierenden Ausgang (34) verbunden mit dem Ausgang (6) der invertierenden Transkonduktanzstufe (8).

## Revendications

1. Montage amplificateur comprenant un étage de transconductance inverseur (8) comportant une entrée (4) et une sortie (6) pour fournir une tension de sortie $U_{out}$, un condensateur (2) couplé entre l'entrée (4) et la sortie (6) de l'étage de transconductance inverseur (8) et un moyen de courant de signal (14) comportant une première sortie (16) couplée à l'entrée (4) de l'étage de transconductance inverseur (8) pour fournir un premier courant de signal $I_{in}$ à l'entrée (4) de l'étage de transconductance inverseur (8), le moyen de courant de signal (14) comprenant en outre une deuxième sortie (18) couplée à la sortie (6) de l'étage de transconductance inverseur (8) pour fournir un deuxième courant de signal à la sortie (6) de l'étage de transconductance inverseur (8), lequel deuxième courant de signal est pratiquement en opposition de phase et pratiquement d'intensité égale au premier courant de signal, **caractérisé en ce que** le montage amplificateur présente une fonction de transfert complexe $U_{out}/I_{in}$ entre la sortie (6) et l'entrée (4) présentant un zéro dans le demi-plan gauche de la fonction de transfert complexe à une fréquence en dehors de la bande passante du montage amplificateur.

2. Montage amplificateur suivant la revendication 1, **caractérisé en ce que** le moyen de courant de signal (14) comprend un deuxième étage de transconductance comportant une entrée (22), une sortie non inverseuse (16) couplée à l'entrée (4) de l'étage de transconductance inverseur (8), et une sortie inverseuse (18) couplée à la sortie (6) de l'étage de transconductance inverseur (8).

3. Montage amplificateur suivant la revendication 2, **caractérisé en ce que** le montage amplificateur comprend en outre un deuxième condensateur (24) couplé entre la sortie (6) de l'étage de transconductance inverseur (8) et l'entrée (22) du deuxième étage de transconductance (14), et un troisième étage de transconductance (26) comportant une entrée (28), une première sortie non inverseuse (30) couplée à la sortie non inverseuse (16) du deuxième étage de transconductance (14), une deuxième sortie non inverseuse (32) couplée à l'entrée (22) du deuxième étage de transconductance (14), et une sortie inverseuse (34) couplée à la sortie (6) de l'étage de transconductance inverseur (8).

FIG.1

FIG.2

FIG.3

FIG.4

EP 0 630 100 B1

FIG.5

FIG.6

FIG.7

7

FIG.8

EP 0 630 100 B1